# EUROPEAN PATENT APPLICATION

(11) **EP 4 443 181 A1**
(43) Date of publication of application: **09.10.2024**
(21) Application number: 24164810.4
(22) Date of filing: 20.03.2024
(51) Int. Cl.: G01R 33/00, G01R 33/06, G01R 33/12, G01R 33/07, G01R 33/09

(54) **MAGNETIC SENSOR AND MAGNETIC FIELD MEASUREMENT DEVICE USING THE SAME**

(30) Priority: 29.03.2023 JP 2023053976
(71) Applicant: TDK Corporation, Tokyo 103-6128 (JP); National University Corporation Yokohama National University, Yokohama-shi, Kanagawa 240-8501 (JP)
(72) Inventor: SHIBUYA, Tomohiko, Tokyo, 103-6128 (JP); TAKEMURA, Yasushi, Kanagawa, 240-8501 (JP); Trisnanto, Suko Bagus, Kanagawa, 240-8501 (JP)
(74) Representative: Epping - Hermann - Fischer

(57) **Abstract**

Disclosed herein is a magnetic sensor that includes: a magnetosensitive element; a cancellation coil cancelling a component on the magnetosensitive element of an AC excitation magnetic field applied to a measurement target including a magnetic material; a receiving coil receiving a primary magnetic field generated from the magnetic material; and a transmitting coil connected to the receiving coil and applying a secondary magnetic field to the magnetosensitive element based on a detection current supplied from the receiving coil.

## Description

### BACKGROUND OF THE ART

### --Field of the Art

The present disclosure relates to a magnetic sensor and a magnetic field measurement device using the magnetic sensor and, more particularly, to a magnetic sensor capable of detecting a feeble magnetic field and a magnetic field measurement device using such a magnetic sensor.

### --Description of Related Art

International Publication WO 2021/100252 discloses a magnetic sensor capable of detecting a feeble magnetic field.

The magnetic sensor disclosed in International Publication WO 2021/100252 has difficulty in ensuring a sufficient S/N ratio due to degradation of its detection sensitivity when distant from a measurement target increases.

### SUMMARY

The present disclosure describes an improved magnetic sensor capable of detecting a feeble magnetic field and a magnetic field measurement device using such a magnetic sensor.

A magnetic sensor according to an aspect of the present disclosure includes: a magnetosensitive element; a cancellation coil cancelling a component on the magnetosensitive element of an AC excitation magnetic field applied to a measurement target including a magnetic material; a receiving coil receiving a primary magnetic field generated from the magnetic material; and a transmitting coil connected to the receiving coil and applying a secondary magnetic field to the magnetosensitive element based on a detection current supplied from the receiving coil.

A magnetic field measurement device according to an aspect of the present disclosure includes the above-described magnetic sensor and an excitation coil that applies the AC excitation magnetic field to the magnetic material.

According to the present disclosure, it is possible to obtain a high S/N ratio even when the distance between the measurement target and the magnetic sensing element is large.

### BRIEF DESCRIPTION OF THE DRAWINGS

The above features and advantages of the present disclosure will be more apparent from the following description of certain preferred embodiments taken in conjunction with the accompanying drawings, in which:
FIG. 1 is a schematic view for explaining the configuration of a magnetic field measurement device 10 according to an embodiment of the present disclosure;
FIG. 2 is a schematic diagram showing an example in which the measurement area A is located outside the inner diameter area of the receiving coil 120;
FIG. 3 is a schematic diagram showing a modification of the magnetic sensor 100;
FIG. 4 is a circuit diagram for explaining the connection between the coils; and
FIG. 5 is a schematic diagram showing an example in which a plurality of magnetic sensors 100 are arranged in an array.

### DETAILED DESCRIPTION OF THE EMBODIMENTS

Some embodiments of the present disclosure will be explained below in detail with reference to the accompanying drawings.

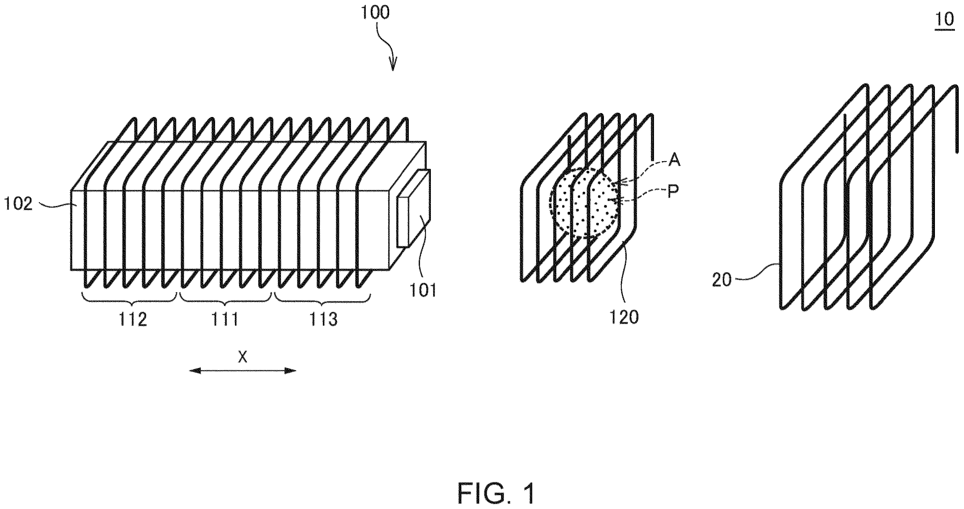

FIG. 1 is a schematic view for explaining the configuration of a magnetic field measurement device 10 according to an embodiment of the technology disclosed herein.

The magnetic field measurement device 10 according to the present embodiment is a device for detecting a magnetic material P positioned within the measurement area A set in a measurement target and includes an excitation coil 20 and a magnetic sensor 100 as illustrated in FIG. 1. The excitation coil 20 applies an AC excitation magnetic field to the measurement target including the magnetic material P to magnetically or physically vibrate the magnetic material P at a predetermined frequency. The vibration of the magnetic material P appears as a change in a magnetic field generated from the magnetic material P. The magnetic sensor 100 detects a change in the magnetic field. The magnetic material P may be nanosized magnetic nanoparticles. Using the magnetic nanoparticles as the magnetic material P allows a human body to be measured. The magnetic field measurement device 10 can also detect a metal member positioned within the measurement area A. When a metal member is present within the measurement area A, an eddy current is generated in the metal member by a magnetic field from the excitation coil 20. The eddy current generates a new magnetic field, which is detected by the magnetic sensor 100.

The magnetic sensor 100 includes a magnetosensitive element 101, a magnetic field concentrator 102 for focusing a magnetic field on the magnetosensitive element 101, a compensation coil 111 wound around the magnetic field concentrator 102, a cancellation coil 112, a transmitting coil 113, and a receiving coil 120.

As the magnetosensitive element 101, magnetoresistive effect elements such as a TMR (Tunnel Magneto-Resistive effect) element, a GMR (Giant Magneto-Resistive effect) element, and an AMR (Anisotropic Magneto-Resistive effect) element; a hall element; and an MI (Magnetic Impedance) element may be used. The sensitivity direction of the magnetosensitive element 101 is the X-direction, and the magnetic field concentrator 102 acts to collect a magnetic field in the X-direction. Although the magnetic field concentrator 102 need not necessarily be used in the present invention, it is preferably used in order to enhance magnetic flux density to be applied to the magnetosensitive element 101.

The compensation coil 111, cancellation coil 112, and transmitting coil 113 are wound around the magnetic field concentrator 102. The coil axis direction of the compensation coil 111, cancellation coil 112, and transmitting coil 113 is the X-direction. Thus, a magnetic field in the X-direction generated by a current flowing in the compensation coil 111, cancellation coil 112, and transmitting coil 113 is applied to the magnetosensitive element 101 through the magnetic field concentrator 102.

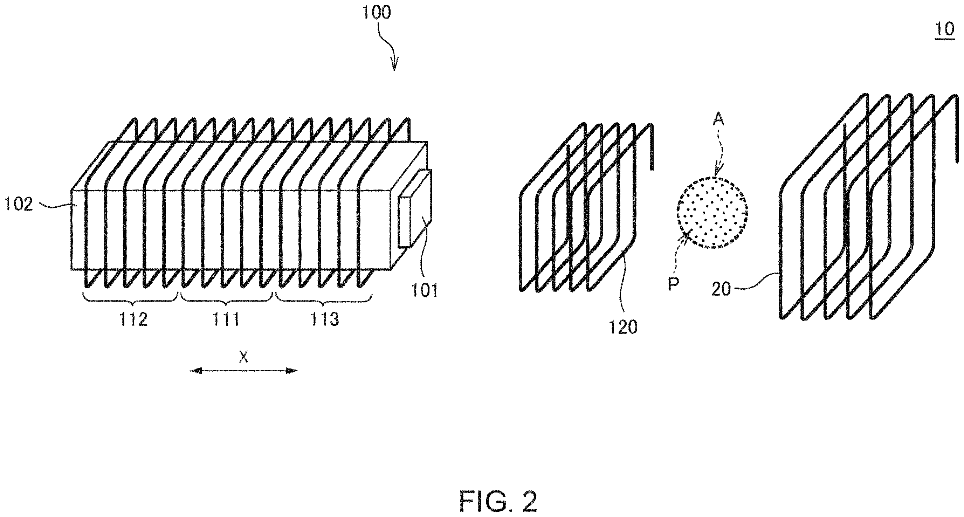

The receiving coil 120 is disposed closer to the measurement area A than the magnetosensitive element 101 is. The coil axis direction of the receiving coil 120 is also the X-direction, whereby a primary magnetic field generated from the magnetic material P is converted to a current by the receiving coil 120. In the example of FIG. 1, the measurement area A is positioned in the inner diameter area of the receiving coil 120; however, this is not essential, but as illustrated in FIG. 2, the measurement area A may be positioned outside the inner diameter area of the receiving coil 120. Even in this case, the distance between the receiving coil 120 and the measurement area A in the X-direction is preferably smaller than the distance between the magnetosensitive element 101 and the measurement area A in the X-direction.

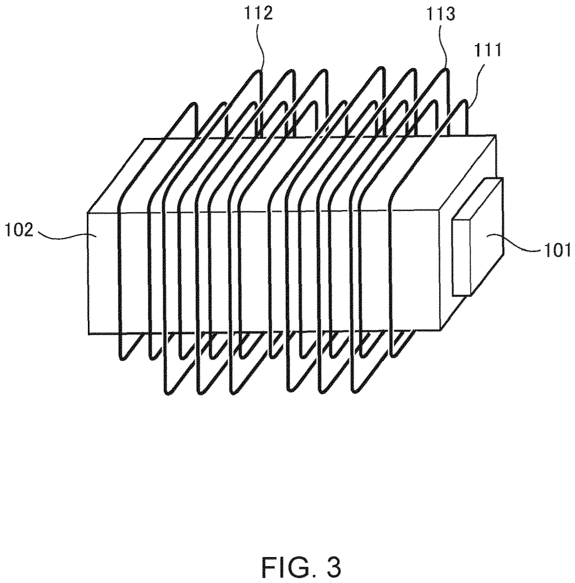

In the example of FIG. 1, the transmitting coil 113, compensation coil 111, and cancellation coil 112 are arranged in the order of proximity to the magnetosensitive element 101; however, the arrangement order of these coils 111 to 113 is not particularly limited. Further, as in the example of FIG. 3, the cancellation coil 112 and transmitting coil 113 may be wound outside the compensation coil 111, which is wound around the magnetic field concentrator 102. With this configuration, the magnetic sensor 100 can be produced by winding the cancellation coil 112 and transmitting coil 113 after preparing an assembly composed of magnetosensitive element 101, magnetic field concentrator 102, and compensation coil 111, thus allowing the cancellation coil 112 and transmitting coil 113 to be adjusted afterward in terms of the number of turns and winding position according to the characteristics of the magnetic field measurement device 10. Also, the size of the magnetic sensor 100 in the X-direction is reduced.

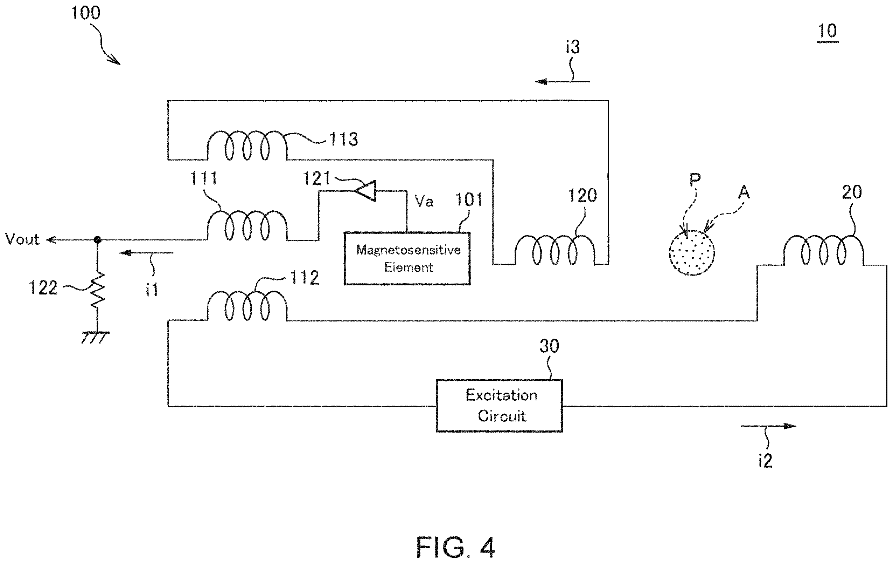

FIG. 4 is a circuit diagram for explaining the connection between the coils.

As illustrated in FIG. 4, a detection signal Va output from the magnetosensitive element 101 is amplified by an amplifier 121 and supplied to the compensation coil 111. The compensation coil 111 acts to cancel a magnetic field to be applied to the magnetosensitive element 101 such that the detection signal Va from the magnetosensitive element 101 becomes zero. That is, the compensation coil 111 generates an opposite-phase magnetic field to the magnetic field to be applied to the magnetosensitive element 101 to thereby achieve closed-loop control. A compensation current i1 flowing in the compensation coil 111 is converted to an output signal Vout by a resistor 122 and output outside.

The cancellation coil 112 is connected in series to the excitation coil 20. The excitation coil 20 is supplied with an excitation current i2 from an excitation circuit 30. The excitation current i2 is an AC signal having a predetermined frequency, whereby the excitation coil 20 generates an AC excitation magnetic field having a predetermined frequency. The AC excitation magnetic field generated by the excitation coil 20 vibrates the magnetic material P at a predetermined frequency, whereby the magnetic material P generates a primary magnetic field changing at a predetermined frequency. However, the AC excitation magnetic field itself from the excitation coil 20 acts as noise against the magnetosensitive element 101. The cancellation coil 112 cancels such noise, that is, cancels a component of the AC excitation magnetic field that can affect the magnetosensitive element 101. To achieve this, the cancellation coil 112 and excitation coil 20 are wound in mutually opposite directions.

The transmitting coil 113 is connected in series to the receiving coil 120. The receiving coil 120 and transmitting coil 113 constitute a closed-loop circuit and are connected neither to an external circuit nor to an external power supply. The closed-loop circuit constituted by the receiving coil 120 and transmitting coil 113 may include a capacitor for phase adjustment. The receiving coil 120 converts the primary magnetic field generated from the magnetic material P to a detection current i3 and supplies this detection signal i3 to the transmitting coil 113. The transmitting coil 113 applies a secondary magnetic field to the magnetosensitive element 101 based on the detection current i3 supplied from the receiving coil 120. Thus, the magnetosensitive element 101 is not only directly applied with the primary magnetic field generated from the magnetic material P but also applied with the secondary magnetic field generated from the transmitting coil 113. The AC excitation magnetic field to be applied to the magnetosensitive element 101 is cancelled by the cancellation coil 112 as described above.

Further, the receiving coil 120 is disposed closer to the measurement area A than the magnetosensitive element 101 is as described above, so that even when the primary magnetic field applied to the magnetosensitive element 101 is feeble, high detection sensitivity can be achieved by the secondary magnetic field applied from the transmitting coil 113. This enhances an S/N ratio to allow detection of a feeble magnetic field.

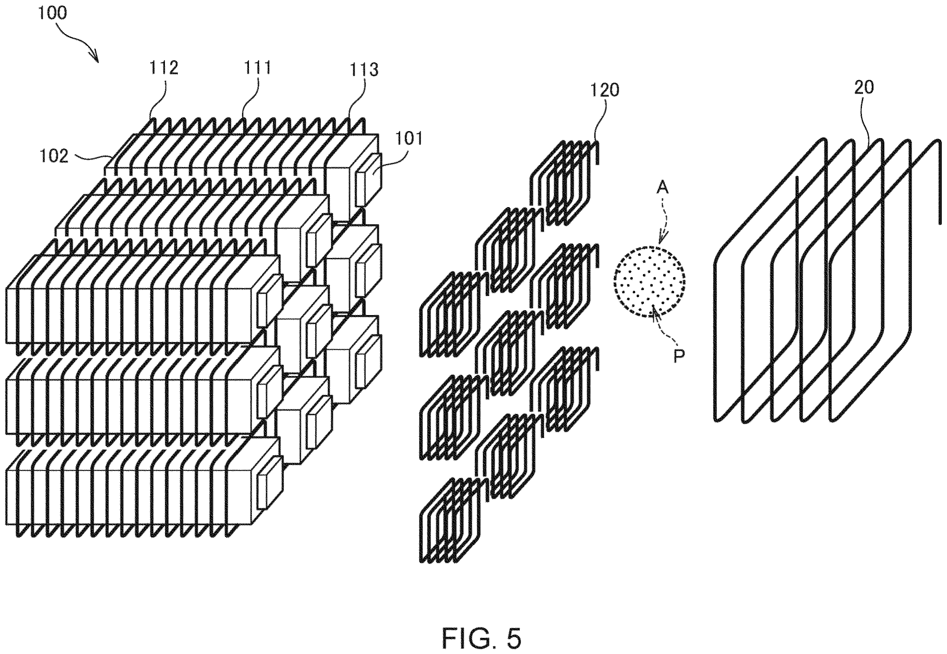

Further, as illustrated in FIG. 5, arranging a plurality of the magnetic sensors 100 in an array allows measurement of the two-dimensional distribution of the magnetic material P included within the measurement area A. In this case, it is not necessary to provide a plurality of the excitation coils 20, and a plurality of the magnetic sensors 100 may be provided for one excitation coil 20.

While the preferred embodiment of the present disclosure has been described, the present disclosure is not limited to the above embodiment, and various modifications may be made within the scope of the present disclosure, and all such modifications are included in the present disclosure.

The technology according to the present disclosure includes the following configuration examples but not limited thereto.

A magnetic sensor according to an aspect of the present disclosure includes: a magnetosensitive element; a cancellation coil that cancels a component of an AC excitation magnetic field, which is to be applied to a measurement target including a magnetic material, that can affect the magnetosensitive element; a receiving coil that receives a primary magnetic field generated from the magnetic material; and a transmitting coil that is connected to the receiving coil and applies a secondary magnetic field to the magnetosensitive element based on a detection current supplied from the receiving coil. Thus, the magnetosensitive element is not only directly applied with the primary magnetic field generated from the magnetic material but also applied with the secondary magnetic field generated from the transmitting coil, and further, the AC excitation magnetic field to be applied to the magnetosensitive element is cancelled by the cancellation coil, thus allowing achievement of a high S/N ratio.

The above magnetic sensor may further include a magnetic field concentrator that focus a magnetic field on the magnetosensitive element, and the cancellation coil and transmitting coil may be wound around the magnetic field concentrator. This can enhance magnetic flux density to be applied to the magnetosensitive element.

The above magnetic sensor may further include a compensation coil that cancels a magnetic field to be applied to the magnetosensitive element. This can achieve closed-loop control.

In the above magnetic sensor, the compensation coil may be wound around the magnetic field concentrator. This allows a compensation magnetic field to be effectively applied to the magnetosensitive element.

In the above magnetic sensor, the cancellation coil and transmitting coil may be wound outside the compensation coil. This allows the cancellation coil and transmitting coil to be adjusted afterward in terms of the number of turns and the like.

A magnetic field measurement device according to an aspect of the present disclosure includes the above-described magnetic sensor and an excitation coil that applies the AC excitation magnetic field to the magnetic material. Thus, there can be provided a magnetic field measurement device having a high S/N ratio.

In the above magnetic field measurement device, a plurality of the magnetic sensors may be provided in an array. This allows measurement of two-dimensional distribution of the magnetic material.

## Claims

1. A magnetic sensor comprising:
a magnetosensitive element;
a cancellation coil cancelling a component on the magnetosensitive element of an AC excitation magnetic field applied to a measurement target including a magnetic material;
a receiving coil receiving a primary magnetic field generated from the magnetic material; and
a transmitting coil connected to the receiving coil and applying a secondary magnetic field to the magnetosensitive element based on a detection current supplied from the receiving coil.

2. The magnetic sensor as claimed in claim 1, further comprising a magnetic field concentrator that focus a magnetic field on the magnetosensitive element,
wherein the cancellation coil and transmitting coil are wound around the magnetic field concentrator.

3. The magnetic sensor as claimed in claim 2, further comprising a compensation coil cancelling a magnetic field to be applied to the magnetosensitive element.

4. The magnetic sensor as claimed in claim 3, wherein the compensation coil is wound around the magnetic field concentrator.

5. The magnetic sensor as claimed in claim 4, wherein the cancellation coil and transmitting coil are wound outside the compensation coil.
